(19) Europäisches Patentamt
European Patent Office
Office européen des brevets

(11) **EP 2 394 969 B1**

(12) **EUROPÄISCHE PATENTSCHRIFT**

(45) Veröffentlichungstag und Bekanntmachung des Hinweises auf die Patenterteilung:
**30.01.2019 Patentblatt 2019/05**

(21) Anmeldenummer: **11003346.1**

(22) Anmeldetag: **21.04.2011**

(51) Int Cl.:
**C03C 3/085** (2006.01)          **C03C 3/087** (2006.01)
**C03C 3/093** (2006.01)          **C03C 3/112** (2006.01)
**H01L 31/0392** (2006.01)          **C03C 3/11** (2006.01)
**H01L 31/032** (2006.01)

(54) **Verwendung von Gläsern für Photovoltaik-Anwendungen**

Use of glasses for photovoltaic applications

Utilisation de verres pour applications photovoltaïques

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.06.2010 DE 102010023366**

(43) Veröffentlichungstag der Anmeldung:
**14.12.2011 Patentblatt 2011/50**

(73) Patentinhaber: **SCHOTT AG**
**55122 Mainz (DE)**

(72) Erfinder:
• **Fechner, Jörg Hinrich, Dr.**
**92637 Weiden (DE)**
• **Ott, Franz, Dr.**
**95692 Konnersreuth (DE)**
• **Speit, Burkhard, Dr.**
**55126 Mainz (DE)**

(74) Vertreter: **Sawodny, Michael-Wolfgang**
**Dreiköniggasse 10**
**89073 Ulm (DE)**

(56) Entgegenhaltungen:
**EP-A1- 2 383 793          EP-A1- 2 492 246
WO-A1-2009/019965          WO-A1-2010/130359
WO-A1-2011/049146          WO-A1-2011/091961
US-A1- 2005 003 136          US-A1- 2009 197 088
US-A1- 2009 325 776**

• **DATABASE WPI Week 201032 Thomson Scientific, London, GB; AN 2010-E91954 XP002663968, -& WO 2010/050591 A1 (ASAHI GLASS CO LTD) 6. Mai 2010 (2010-05-06)**
• **Thomas P. Seward, Terese Vascott: "High Temperature Glass Melt Property Database for Process Modeling", 2005, XP007914656, ISBN: 1-57498-225-7 Seiten 269-274, * Seite 269 - Seite 274; Tabellen I-VI ***
• **Alexander Fluegel: "Water Solubility" In: Thomas P. Seward et al.: "High Temperature Glass Melt Property Database for Process Modeling", 2005, XP007921825, ISBN: 1-57498-225-7 pages 243-244, * the whole document ***

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft die Verwendung von speziellen Gläsern für Photovoltaik-Anwendungen.

Photovoltaik ist die direkte Umwandlung von Sonnenenergie in elektrische Energie. Die photovoltaische Energiewandlung erfolgt mit Solarzellen, in größeren Einheiten als sogenannte Solarmodule, in Photovoltaikanlagen. Diese Art der Stromerzeugung findet beispielsweise Anwendung auf Dachflächen, bei Parkscheinautomaten, in Taschenrechnern, an Schallschutzwänden und auf Freiflächen. Die erzeugte Elektrizität kann entweder vor Ort genutzt, in Akkumulatoren gespeichert oder in Stromnetze eingespeist werden. Bei Einspeisung der Energie in das öffentliche Stromnetz wird die von den Solarzellen erzeugte Gleichspannung von einem Wechselrichter in Wechselspannung umgewandelt.

Solarzellen werden nach verschiedenen Kriterien eingeordnet. Das gängigste Kriterium ist die Materialdicke, man unterscheidet Dick- und Dünnschichtzellen. Ein weiteres Kriterium ist das verwendete Material. Weltweit am häufigsten ist Silizium, wie monokristalline Zellen (c-Si), polykristalline oder multikristalline Zellen (poly-Si oder mc-Si), amorphes Silicium (a-Si) und kristallines Silizium, z.B. mikrokristallines Silizium ($\mu$c-Si). Es kommen auch Halbleitermaterialien zum Einsatz: z.B. in III-V-Halbleiter-Solarzellen, wie GaAs-Zellen, II-VI-Halbleitersolarzellen, wie CdTe-Zellen, oder I-III-VI-Halbleiter-Solarzellen, insbesondere CIS- oder CIGS-Solarzellen (Chalkopyrite, engl. copper, indium, gallium, sulfur, oder selenium). CIGS steht für $Cu(In_{1-x},Ga_x)(S_{1-y},Se_y)_2$ und ist eine bekannte Dünnschichttechnologie für Solarzellen und steht als Abkürzung für die verwendeten Elemente Kupfer, Indium, Gallium, Schwefel und Selen. Wichtige Beispiele sind $Cu(In,Ga)Se_2$ (Kupfer-Indium-Gallium-Diselenid) oder $CuInS_2$ (Kupfer-Indium-Disulfid).

Dünnschichtsolarzellen gibt es in verschiedenen Variationen, je nach Substrat und aufgedampften Materialien. Verglichen mit kristallinen Solarzellen aus Siliziumwafern sind Dünnschichtzellen etwa 100-mal dünner. Dünnschichtzellen unterscheiden sich von den traditionellen Solarzellen (kristallinen Solarzellen, basierend auf Siliziumwafern) vor allem in ihren Produktionsverfahren und durch die Schichtdicken der eingesetzten Materialien. Ein Vorteil der Dünnschichttechnologie ist eine vergleichsweise kurze Wertschöpfungskette, da Halbleiter-, Zell- und Modulherstellung in einer Hand liegen. Insbesondere Dünnschichtsolarzellen auf Verbundhalbleiterbasis, wie beispielsweise CdTe oder CIGS zeigen eine exzellente Stabilität als auch sehr hohe Energiekonversionseffizienzen. Verbundhalbleiter zeichnen sich vor allem dadurch aus, dass sie direkte Halbleiter sind und bereits in einer relativ dünnen Schicht (ca. 2 $\mu$m) das Sonnenlicht effektiv absorbieren. Mit Hilfe der Dünnschichttechnologie können besonders langlebige Module erzeugt werden, die über viele Jahre stabile Wirkungsgrade zeigen. Eine weitere Stärke von Dünnschichtsolarzellen ist, dass sie einfacher und großflächiger produziert werden können. Diese machen daher heute den größten Marktanteil aus.

Die Abscheidetechnologien für solche dünnen photoaktiven Schichten erfordern jedoch hohe Prozeßtemperaturen, um hohe Wirkungsgrade zu erzielen. Typische Temperaturbereiche liegen hierbei zwischen 450 bis 600°C, wobei die Maximaltemperatur praktisch nur durch das Substrat begrenzt wird. Für großflächige Anwendungen wird als Substrat im Allgemeinen Glas verwendet. Hierbei handelt es sich in der Regel um gefloatetes Kalknatronglas (Fensterglas), das aufgrund wirtschaftlicher Erwägungen, insbesondere den geringen Kosten, und wegen seines in etwa an die Halbleiterschichten angepaßten Wärmeausdehnungskoeffizienten (CTE, Coefficient of thermal expansion), eingesetzt wird. Solarzellen, in denen eine Chalkopyrit-Halbleiterschicht auf ein Kalknatronglas als Substrat aufgebracht wird, sind beispielsweise der DE 43 33 407 C1 und der WO 94/07269 A1 zu entnehmen.

Jedoch spielt die Kostensenkung auch für die Dünnschichttechnologie in der Photovoltaik eine immer größer werdende Rolle. Die Senkung der Kosten kann vor allem durch Reduktion des Materialverbrauchs, eine Verkürzung der Prozeßzeiten und damit verbunden einem höherem Durchsatz als auch der Erhöhung der Ausbeute erreicht werden.

Kalknatronglas besitzt eine Tranformationstemperatur von ca. 490 - 520°C und macht dadurch alle folgenden Prozesse oberhalb 525°C (bei CIGS Beschichtungen übliche Prozesstemperaturen 530°C - derzeit max. 580°C) schwierig, da es ansonsten zum sogenannten "sagging" bei Flachgläsern bzw. "Bow" bei Rohrgläsern, d.h. zu Verwölbungen, führt und sich zu verbiegen beginnt. Dies gilt umso mehr je größer das zu beschichtende Substrat ist und je mehr sich die Prozesstemperatur der Transformationstemperatur (Tg) des Glases nähert bzw. darüber hinausgehen. Verwölbungen oder Verbiegungen führen insbesondere bei sogenannten Inline-Prozessen/-Anlagen zu Problemen, wodurch der Durchsatz und die Ausbeute sich deutlich verschlechtern.

Weiterhin ist allgemein bekannt, dass eine Verbesserung der elektrischen Eigenschaften von Dünnschichtsolarzellen auf Verbundhalbleiterbasis erzielt werden kann, wenn diese bei höheren Temperaturen, d.h. > 550°C, abgeschieden werden. Es wäre demnach wünschenswert, den Abscheideprozess von Verbundhalbleiterdünnschichten bei höheren Temperaturen durchzuführen, um so höhere Abscheide- und Abkühlraten sowie eine gesteigerte Leistungsfähigkeit des photovoltaischen Bauteils zu erreichen. Wie bereits erwähnt, kann dies mit Kalknatronglas als Substrat nicht erzielt werden.

Zahlreiche Gläser zur Verwendung in der Photovoltaik sind aus dem Stand der Technik bereits bekannt: Eine Alternative für Kalknatronglas als Substratglas für Dünnschicht-Photovoltaik-Module auf Verbundhalbleiter-Basis wird beispielsweise in der DE 100 05 088 C1 beschrieben. So offenbart die DE 100 05 088 C1 ein alkalihaltiges Aluminoborosilikatglas, jedoch liegt dessen thermischer Wärmeausdehnungskoeffizient (CTE) $\alpha_{20/300}$ im Bereich zwischen 4,5 und 6,0 x $10^{-6}$/K, was dem CTE der ersten Schicht, d.h. dem Rückkontakt (beispielsweise aus Molybdän), entspricht.

Auf solchen Substraten ist daher die Schichthaftung einer CIGS-Schicht nicht gewährleistet. Zusätzlich enthält das Glas bis zu 8 Gew.-% $B_2O_3$, welches sich insbesondere bei hohen Temperaturen, d.h. > 550°C, aus dem Substrat verflüchtigen / ausdiffundieren kann und als Halbleitergift im CIGS-System wirkt. Gewünscht wäre ein Substrat, welches zwar Bor enthalten kann, dieses sich allerdings nicht verflüchtigt und damit unschädlich für den Abscheideprozess und damit die Halbleiterschicht ist.

In der JP 11-135819 A wird weiterhin eine Solarzelle auf Verbundhalbleiter-Basis beschrieben, wobei das Glassubstrat eine ähnliche Zusammensetzung zu Kalknatronglas aufweist. Allerdings enthalten diese Gläser einen hohen Anteil an Erdalkali-Ionen, was dazu führt, dass die Beweglichkeit der Alkali-Ionen im Substrat drastisch reduziert bzw. verhindert wird. Es ist allgemein bekannt, dass Alkali-Ionen eine wichtige Rolle während der Schichtabscheidung der Verbundhalbleiterdünnschichten spielen und daher ist es erwünscht ein Substrat für den Abscheideprozess zur Verfügung zu haben, welches eine räumlich, als auch zeitlich homogene Alkali-Ionen Abgabe ermöglicht.

Ferner offenbart die DE 10 2006 062 448 A1 ein Photovoltaik-Modul, umfassend eine Elektrodenschicht, Dünnschichtsilizium und eine Konverterplatte aus dotiertem Glas und/oder dotierter Glaskeramik, wobei die aus Glas oder Glaskeramik bestehende Konverterplatte einen Brechungsindex n von wenigstens 1,49 aufweist und mit zumindest einem Buntmetall und/oder zumindest einem Seltenerd-Metall dotiert ist. Das Photovoltaikmodul führt aufgrund der Konverterplatte aus dotiertem Glas und/oder dotierter Glaskeramik zu verminderten Oberflächen-Reflexionsverlusten. Das Photovoltaikmodul weist ferner einen Wassergehalt von weniger als 40 mmol/l auf. Das Buntmetall ist ausgewählt aus $MnO_2$, $CrO_3$, NiO und/oder einer Kombination davon. Die Seltenerd-Metalle sind ausgewählt aus zwei- oder drei-wertigen Oxiden und Fluoriden von Samarium, Europium, Thulium, Terbium, Yttrium, und Ytterbium und/oder Kombinationen davon. Die erfindungsgemäß verwendeten Gläsern sollen nicht mit Verbindungen, ausgewählt aus $MnO_2$, $CrO_3$, NiO und/oder Kombinationen hiervon, dotiert sein; die Gläser, verwendet in der vorliegenden Erfindung, sollen auch nicht mit Verbindungen, ausgewählt aus zwei- oder drei-wertigen Oxiden und Fluoriden von Samarium, Europium, Thulium, Terbium, Yttrium, und Ytterbium und/oder Kombinationen dotiert sein. Die Gläser gemäß der DE 10 2006 062 448 A1 betreffen völlig andere Gläser, die mit den erfindungsgemäß verwendeten Gläsern nicht vergleichbar sind.

Bislang wurde im Stand der Technik kaum berücksichtigt, dass der Wassergehalt der Gläser für die Verwendung in Solarzellen von Bedeutung sein könnte. Das einzige Dokument aus dem Stand der Technik, das sich hiermit beschäftigt, ist die DE 10 2009 020 954 (entspricht der DE 10 2009 050 987 B3). In der DE 10 2009 020 954 wird ein $Na_2O$-haltiges Mehrkomponentensubstratglas beschrieben, das einen Wassergehalt im Bereich von 25 bis 80 mMol/Liter aufweist, bestimmt anhand der Intensität der ß-OH-Streckschwingung im Bereich von 2700 nm im IR-Spektrum. Diese Gläser sind nur dann als Substratgläser für Dünnschichtsolarzellen geeignet, wenn deren Wassergehalt mindestens 25 mMol/Liter beträgt. Dies wird darauf zurückgeführt, dass nur bei einem Wassergehalt von 25 mMol/Liter und mehr die im Glas vorhandenen Halbleitergifte, wie Eisen, Arsen und Bor, chemisch gebunden vorliegen und somit nicht mehr vom Glas in den Halbleiter gelangen können. Bei der beschriebenen Glaszusammensetzung spielt weiterhin eine hohe Natriumionenbeweglichkeit im Glas bei Temperaturen > 600°C eine Rolle. Dabei ist der beschriebene höhere Wassergehalt ebenfalls wesentlich. Ein hoher Natriumgehalt zusammen mit dem hohen Wassergehalt von 25 bis 80 mMol/Liter verbessert gemäß der DE 10 2009 020 954 die Leistungsfähigkeit einer Photovoltaik-Solarzelle, besonders auf Basis der CIGS-Technologie.

Weiterhin ist aus dem Stand der Technik die WO 2011/091961 A1 bekannt, die nur für die Beurteilung der Neuheit relevant ist, und sich auf eine Photovoltaikzelle, bevorzugt Dünnschicht-Photovoltaikzelle, bezieht, umfassend ein Substrat, hergestellt aus einem Aluminosilikatglas. Gemäß Beispiel 4 wird ein Glas, zusammengesetzt aus (in Gew.-%): 55,70 $SiO_2$, 15,00 $Al_2O_3$, 11,10 $Na_2O$, 4,00 $K_2O$, 3,90 MgO, 3,00 CaO, 4,50 BaO, 2,50 $ZrO_2$, 0,20 $SO_3$ und 0,1 F, beschrieben.

Gemäß der EP 2 383 793 A1, die nur für die Beurteilung der Neuheit relevant ist, wird eine Solarzelle offenbart, umfassend eine Doppelröhre, aufgebaut aus 2 Glasröhren, die sich im Durchmesser unterscheiden, sowie eine zwischen den 2 Glasröhren gebildeten photovoltaischen Konversionsschicht, wobei die Doppelröhre an beiden Enden eines Teils verschlossen ist, in dem die photovoltaische Konversionsschicht gebildet ist, wobei mindestens eine der beiden Glasröhren aus einem Glas aufgebaut ist, das in Gew.-%, bezogen auf die Oxide, aufweist: 60 bis 75% $SiO_2$, 4 bis 10% $Al_2O_3$, 0 bis 5% $B_2O_3$, 0 bis 5% MgO, 0,5 bis 5% CaO, 0 bis 0,5% SrO, 0 bis 11% BaO, 10 bis 16% $Na_2O$, 0 bis 10% $K_2O$ und 0,5 bis 10% $ZrO_2$.

Aus der WO 2011/049146 A1, die nur für die Beurteilung der Neuheit relevant ist, wird eine Glasplatte für Cu-In-Ga-Se (CIGS)-Solarzellen beschrieben, wobei das Glas in Mol-%, bezogen auf die Oxide, umfasst: : 60 bis 75% $SiO_2$, 3 bis 10% $Al_2O_3$, 0 bis 3% $B_2O_3$, 5 bis 18% MgO, 0 bis 5% CaO, 4 bis 18,5 % $Na_2O$ und 0 bis 17% $K_2O$ sowie SrO, BaO und $ZrO_2$ in einer Gesamtmenge von 0 bis weniger als 10% enthält, mit $K_2O/(Na_2O+K_2O)$ = 0 bis 0,5 und einer Glasübergangstemperatur über 550°C.

Die WO 2010/050591 A1 offenbart eine Solarzelle, umfassend eine Doppelröhre, aufgebaut aus 2 Glasröhren, die sich im Durchmesser unterscheiden, sowie eine zwischen den 2 Glasröhren gebildeten photovoltaischen Konversionsschicht, wobei die Doppelröhre an beiden Enden der Teile verschlossen ist, wo die photovoltaische Konversionsschicht gebildet ist, wobei mindestens eine der beiden Glasröhren aus einem Glas aufgebaut ist, das in Gew.-%, bezogen auf die Oxide, enthält: 60 bis 70% $SiO_2$, 4 bis 10% $Al_2O_3$, 0 bis 3% $B_2O_3$, 0 bis 4% MgO, 2 bis 9% CaO, 1 bis 10% SrO, 0 bis 2% BaO, 10 bis 16% $Na_2O$, 0 bis 5% $K_2O$, 0 bis 2% $ZrO_2$ und 0 bis 2% $CeO_2$.

Die US 2005/0003136 A1 bezieht sich auf eine Glaszusammensetzung, umfassend, in Gew.-%: 59 bis 68 % $SiO_2$, 9,5 bis 15% $Al_2O_3$, 0 bis 1 % $Li_2O$, 3 bis 18 % $Na_2O$, 0 bis 3,5% $K_2O$, 0 bis 15% MgO, 1 bis 15% CaO, 0 bis 4,5% SrO, 0 bis 1% BaO, 0 bis 2% $TiO_2$ und 1 bis 10% $ZrO_2$.

Die EP 2 492 246 A1 bezieht sich auf eine Glasplatte für ein Substrat, umfassend als Glasmatrixzusammensetzung in Mol-% auf Oxidbasis: 67 bis 72 $SiO_2$, 1 bis 7 $Al_2O_3$, 0 bis 4 $B_2O_3$, 11 bis 15 MgO, 0 bis 3 CaO, 0 bis 3 SrO, 0 bis 4 BaO, 0 bis 4 $ZrO_2$, 8 bis 15 $Na_2O$ und 0 bis 7 $K_2O$, wobei $SiO_2$ + $Al_2O_3$ von 71 bis 77 ist, MgO + CaO + SrO + BaO von 11 bis 17 ist, $Na_2O$ + $K_2O$ ist 8 bis 17 und $K_2O$ / ($Na_2O$ + $K_2O$) $\leq$ 0,13 x ($SiO_2$ + $Al_2O_3$ +0,5 $B_2O_3$ + 0,3BaO)- 9,4 erfüllt ist und wobei die Glasplatte einen $\beta$-OH-Wert ($mm^{-1}$) von 0,05 bis 0,5 und ein Wärmeschrumpfungsverhältnis (C) von 16 ppm oder weniger aufweist.

Der vorliegenden Erfindung liegt die Aufgabe zugrunde, die Nachteile des Standes der Technik zu vermeiden, und Gläser bereitzustellen, die für Photovoltaik-Anwendungen besonders gut geeignet sind und dort zu verbesserten Ergebnissen führen. Insbesondere soll es durch die erfindungsgemäß zu verwendenden Gläser möglich werden, eine gegenüber dem Stand der Technik verbesserte Dünnschichtsolarzelle mit höherem Wirkungsgrad bereitzustellen.

Erfindungsgemäß wird die Aufgabe gelöst durch die.

Verwendung eines Glases für Photovoltaik-Anwendungen, wobei das Glas einen Wassergehalt von < 10 mMol/Liter aufweist und die folgende Glaszusammensetzung (in Gew.-% auf Oxidbasis) aufweist oder hieraus besteht:

| | |
|---|---|
| $SiO_2$ | 49 - 69 Gew.-% |
| $B_2O_3$ | 0 - 2 Gew.-%, |
| bevorzugt $B_2O_3$ | 0 Gew.-%, |
| $Al_2O_3$ | >4,7 - 19 Gew.-%, |
| bevorzugt $Al_2O_3$ | > 5 - 17 Gew.-%, |
| $Li_2O$ | 0 - 4 Gew.-%, |
| bevorzugt $Li_2O$ | 0 - <0,3 Gew.-%, |
| $Na_2O$ | >10- 18 Gew.-%, |
| bevorzugt | >15 - 18 Gew.-%, |
| $K_2O$ | >0 - 8 Gew.-%, |
| bevorzugt $K_2O$ | >0 - <5 Gew.-%, |
| insbesondere $K_2O$ | >0 - <4 Gew.-%, wobei die |
| Summe $Li_2O$+ $Na_2O$+ $K_2O$ | >10 - 19 Gew.-% beträgt, und |
| MgO | 0 - 6 Gew.-% |
| CaO | 0 - <5 Gew.-% |
| SrO | 0 - 7 Gew.-%, |
| bevorzugt SrO | 0 - <0,5 Gew.-%, |
| BaO | 0 - 10 Gew.-%, |
| bevorzugt BaO | 1 - 9 Gew.-%, |
| besonders bevorzugt BaO | 2 - 4 Gew.-%, wobei die |
| Summe MgO+CaO+SrO+BaO | 7 - 15 Gew.-% beträgt, und |
| F | 0 - 3 Gew.-% |
| $TiO_2$ | 0 - 6 Gew.-%, |
| bevorzugt $TiO_2$ | >0,1 - 5 Gew.-%, |
| $Fe_2O_3$ | 0 - 0,5 Gew.-% |
| $ZrO_2$ | >0 - 6 Gew.-%, |
| bevorzugt $ZrO_2$ | 1 - 6 Gew.-%, |
| besonders bevorzugt $ZrO_2$ | 1,5 - 5 Gew.-%, wobei |
| die Summe BaO+$ZrO_2$ | 2 - 15 Gew.-% beträgt, |
| bevorzugt | 3 - 15 Gew.-% beträgt, |
| ZnO | 0 - 3 Gew.-%, |
| bevorzugt ZnO | 0 - 2 Gew.-%, |
| besonders bevorzugt | 0,3 - 1,8 Gew.-% |
| $CeO_2$ | 0 - 3 Gew.-% |
| $WO_3$ | 0 - 3 Gew.-% |

(fortgesetzt)

| | |
|---|---|
| $Bi_2O_3$ | 0 - 3 Gew.-% |
| $MoO_3$ | 0 - 3 Gew.-%, |

wobei das Glas übliche Läutermittel, wie z.B. Sulfate, Chloride, $Sb_2O_3$, $As_2O_3$, $SnO_2$ aufweist.

In überraschender Weise und in völliger Abkehr vom Stand der Technik gemäß der DE 10 2009 020 954 sind Gläser mit Wassergehalten unterhalb 10 mMol/Liter ebenfalls für Photovoltaik-Anwendungen geeignet. Dies ist unerwartet, da gemäß der DE 10 2009 020 954 nur Gläser mit hohem Wassergehalten von 25 bis 80 mMol/Liter in der Photovoltaik zum Einsatz kommen können.

Generell muß bei der Herstellung von Halbleitern vermieden werden, dass Halbleitergifte in die Schichten gelangen, da diese die Leistungsfähigkeit der Schicht drastisch reduzieren. Besonders bei Hochtemperaturprozessen, wie beispielsweise der Herstellung von CIGS-basierten Solarzellen, gilt es zu verhindern, dass Halbleitergifte, wie Eisen, Arsen oder Bor, sich während der Herstellung aus dem Glas verflüchtigen oder herausdiffundieren und in die Halbleiterschicht gelangen. Halbleitergifte sind Elemente oder Verbindungen, welche die Leistungsfähigkeit eines Halbleiters stören, die u.a. zu aktiven Rekombinationszentren werden und zu einem Einbruch von Leerlaufspannung und Kurzschlussstrom führen können. Überraschenderweise wurde nun gefunden, dass Gläser in einem Hochtemperaturprozess eingesetzt werden können, ohne Halbleitergifte, wie Eisen, Arsen und Bor, freizusetzen, wenn diese einen Wassergehalt von < 10 mMol/Liter aufweisen. Der Wassergehalt bezieht sich hierbei nicht nur auf vorhandenes freies Wasser, sondern auch auf $H_2O$ in Form von Kristallwasser (Komplex-gebundenes $H_2O$) sowie auf Wasser als sog. "Hydrathülle" um Kationen aber auch Anionen. Sollten Halbleitergifte in der ausgewählten Glaszusammensetzung vorhanden sein, werden diese chemisch durch die Gegenwart von Wasser gebunden und können auch bei hohen Temperaturen wie > 550°C das Glas nicht verlassen. Außerdem kann durch einen geringen Wassergehalt die Diffusion des Halbleitergiftes Wasser selbst verringert bzw. verhindert werden.

Die Untergrenze für den Wassergehalt der verwendeten Gläser liegt bevorzugt bei > 1 mMol/Liter, bevorzugter > 2 mMol/Liter, besonders bevorzugt > 5 mMol/Liter. Die Gläser sollten nicht völlig wasserfrei sein; dies kann zwar in Einzelfällen vorteilhaft sein, ist jedoch nicht bevorzugt, damit ein etwaiges Halbleitergift im Glas durch das vorhandene Wasser noch gebunden werden kann.

Für Anwendungen im Photovoltaik-Bereich hat es Vorteile, wenn im verwendeten Glas ein Wassergehalt, bevorzugt im Bereich zwischen 5 mMol/Liter und 10 mMol/Liter, vorliegt. So werden Halbleitergifte durch den vorhandenen Wassergehalt noch im Glas in ausreichendem Maße chemisch gebunden und können so nicht ohne weiteres aus dem Glas in den Halbleiter gelangen. Ferner wurde festgestellt, dass ein Wassergehalt über 25 mMol/Liter insbesondere für Photovoltaik-Anwendungen im CIGS-Bereich (Kupfer-Indium-Gallium-Schwefel oder Selen) nachteilig sein kann, da insbesondere die Leistungsfähigkeit einer Photovoltaik-Solarzelle abnehmen kann.

Ein weiterer Vorteil des erfindungsgemäß bevorzugten Wassergehalts im Bereich zwischen 5 und 10 mMol/Liter ist, dass die Glaseigenschaften der Gläser nicht nachteilig beeinflußt werden. Bei Wassergehalten über 25 mMol/Liter kann es demgegenüber durchaus zu Änderungen der Glaseigenschaften kommen, die sich nachteilig auswirken könnten.

Die Bestimmung des quantitativen Wassergehalts erfolgt im Rahmen der vorliegenden Erfindung wie in der DE 10 2009 020 954 offenbart, anhand der OH-Streckschwingung im Bereich um 2700 nm eines IR-Spektrums, beispielsweise mit einem handelsüblichen Nicolet-FTIR-Spektrometer mit angeschlossener Computerauswertung. Hierzu wird zunächst die Absorption im Wellenlängenbereich von 2500 bis 6500 nm gemessen und dann das Absorptionsmaximum um 2700 nm bestimmt. Der Absorptionskoeffizient $\alpha$ wird anschließend mit der Probendicke d, der Reintransmission $T_i$ und dem Reflektionsfaktor P wie folgt berechnet:

$$\alpha = 1/d*lg(1/T_i) \ [cm^{-1}],$$

wobei $T_i$ = T/P mit der Transmission T. Der Wassergehalt errechnet sich dann aus

$$c = \alpha /e,$$

wobei e der praktische Extinktionskoeffizient [$l*Mol^{-1}*cm^{-1}$] ist und für den oben genannten Auswertebereich als konstanter Wert von e = 110 $l*Mol^{-1}*cm^{-1}$, bezogen auf die Mol $H_2O$, angesetzt wird. Der e-Wert ist der Arbeit von H. Frank und H. Scholze aus den "Glastechnischen Berichten", 36. Jahrgang, Heft 9, Seite 350, entnommen.

Die Einstellung des Wassergehaltes in Gläsern auf < 10 mMol/Liter kann in unterschiedlicher Weise erreicht werden. Beispielsweise kann dies durch gezielte Auswahl der Ausgangsmaterialien und der Verfahrensbedingungen bei Herstellung des Glases erzielt werden. Eine Absenkung des vorhandenen Wassergehalts kann beispielsweise dadurch erreicht werden, dass weder durch die Ausgangsmaterialien, noch bei Herstellung des Glases zusätzliches unerwünschtes Wasser in das Glas eingetragen wird. Die Ausgangsmaterialien können beispielsweise speziell getrocknet werden. Auch die Auswahl besonders geeigneter Läutermittel, wie z. B. Sulfate oder Chloride, kann zur Verringerung des Wassergehalts beitragen. Weiterhin können die Schmelzbedingungen derart kontrolliert werden, dass möglichst wenig Wasser in die Schmelze gelangen kann. Besonders bevorzugt wird das Glas in Schmelzwannen erschmolzen, die aufgrund ihrer Befeuerung und/oder Heiztechnik nur geringe Gehalte an $H_2O$ ins Glas eintragen. Dies sind z.B. vollektrische Beheizungssysteme oder konventionelle Beheizungssysteme (Gas/Öl), wobei durch entsprechende Abschirmung und/oder Kontrolle des Systems der Wassergehalt in geeigneter Weise reduziert werden kann. Es kann beispielsweise auch besonders trockene Luft durch die Schmelze durchgeblasen werden. Eine weitere Möglichkeit, den Wassergehalt im Glas auf unter 10 mMol/Liter zu verringern, ist durch Wahl einer geeigneten Glaszusammensetzung. Eine Erhöhung des Wassergehalts auf den als bevorzugt beschriebenen Bereich kann zum Beispiel durch gezielte Auswahl von wasserreichen Rohstoffen mit Wasser im Kristallgitter, wie z.B. von $Al(OH)_3$ statt $Al_2O_3$, erreicht werden. Eine weitere Möglichkeit ist es, eine sauerstoffreiche Gasatmosphäre im Schmelzprozess, auch bekannt als "Oxyfuel", zu realisieren, wodurch der Wassergehalt des Glases erhöht werden kann, um im erfindungsgemäßen Bereich eingestellt zu werden.

Erfindungsgemäß bevorzugte Gläser weisen nicht nur einen Wassergehalt < 10 mMol/Liter auf, sondern zeigen auch eine Transformationstemperatur Tg im Bereich von > 580°C, bevorzugt > 600°C. Gleichzeitig sind Gläser mit einer Verarbeitungstemperatur ("VA") im Bereich von < 1270°C, bevorzugt <1200°C und insbesondere <1150°C besonders bevorzugt. Zusätzlich ist es von Vorteil, wenn die erfindungsgemäß verwendeten Gläser eine charakteristische thermische Dehnung im Bereich von 7 bis 11 x $10^{-6}$/K (thermischer Wärmeausdehnungskoeffizient), bevorzugter 8 bis 10 x $10^{-6}$/K, ganz besonders bevorzugt 8,5 bis 10 x $10^{-6}$/K im Temperaturbereich von 20 bis 300°C aufweisen.

Um diese Eigenschaften, insbesondere eine hohe Transformationstemperatur Tg und eine relativ niedrige Verarbeitungstemperatur, umsetzen zu können, enthält das erfindungsgemäß verwendete Glas bevorzugt hohe Gehalte an $Na_2O$ von >10 Gew.-%, bevorzugt > 12 Gew.-%, besonders bevorzugt > 15 Gew.-%. Auch für spezielle Anwendungen der erfindungsgemäß verwendeten Gläser als Substratgläser, beispielsweise als CIGS-Substratgläser, ist ein $Na_2O$-Gehalt von >10 Gew.-% ein wesentliches Merkmal. Natrium leistet hierbei einen signifikanten Beitrag zur Steigerung des Wirkungsgrades, indem Na-Ionen in die CIGS-Schicht diffundieren können. Der hohe Natrium-Gehalt trägt daher entscheidend dazu bei, dass ein hoher Tg-Wert bei gleichzeitig niedriger Verarbeitungstemperatur erzielt wird.

Insbesondere aufgrund des hohen $Na_2O$-Gehalts von > 10 Gew.-%, bevorzugt > 12 Gew.-%, ganz besonders bevorzugt >15 Gew.-%, gelingt es auch besonders gut, die thermische Wärmeausdehnung bzw. den thermischen Wärmeausdehnungskoeffizienten (CTE) im oben genannten Bereich zu halten, der üblicherweise bei Kalknatrongläsern (Alkali-Erdalkali-Silicatgläser) erzielt wird, und die Verarbeitungstemperatur in den Bereich von Kalknatrongläsern abzusenken.

Ein weiterer Vorteil bei Verwendung eines hohen Gehalts an Natrium ist, dass Natrium einen positiven Einfluss auf die Kristallitstruktur und Kristalldichte aber auch auf die Kristallitgröße und -orientierung der Halbleiterschicht hat. Wesentliche Aspekte hierbei scheinen der verbesserte Chalkogeneinbau in das Kristallgitter sowie die Passivierung von Korngrenzen zu sein. Hierdurch resultieren erheblich bessere Halbleitereigenschaften, insbesondere eine Reduktion der Rekombination im Volumenmaterial und damit eine höhere Leerlaufspannung. Dies kann einen höheren Wirkungsgrad der Solarzelle zur Folge haben.

Von Kalknatrongläsern ist weiterhin bekannt, dass deren räumliche und insbesondere zeitliche Abgabe von Alkali-Ionen aus dem Substrat in die Halbleiterschicht während des Abscheidungsprozesses sehr inhomogen ist.

Demgegenüber kann das erfindungsgemäß verwendete Substratglas neben der Eigenschaft als Träger auch dazu dienen, die gezielte Abgabe von Natriumionen/- atomen in den Halbleiter zu unterstützen. Die gezielte Abgabe von Alkali-Ionen, insbesondere Natrium, sowohl zeitlich als auch räumlich (über die Beschichtungsfläche) homogen über den gesamten Halbleiterabscheidungsschritt, ist von entscheidender Bedeutung für die Herstellung von hocheffizienten auf Verbundhalbleiter basierenden Solarzellen, insbesondere mit der Maßgabe, dass zusätzliche Verfahrensschritte, wie das Zudotieren von Natrium, wegfallen können, um einen kosteneffizienten Prozess zu realisieren. Es ist zweckmäßig, wenn das Substratglas Na-Ionen/Na-Atome bei Temperaturen um Tg abgibt, was eine erhöhte Beweglichkeit des Alkali-Ions voraussetzt.

Überraschenderweise hat sich nun gezeigt, dass die Beweglichkeit von Alkali-Ionen in Gläsern mit dem erfindungsgemäß geringen Wassergehalt in hohem Maße gegeben ist. Die Ionenbeweglichkeit der Natrium-Ionen und deren leichtere Austauschbarkeit wird durch geringe Restwassergehalte in der Glasstruktur positiv beeinflusst. Für Glassubstrate, die aufgrund des geringen Wassergehalts eine hohe Alkali-Ionen Beweglichkeit zeigen, können die Alkali-Ionen räumlich homogen über die gesamte Substratfläche an die darüber liegenden Schichten abgegeben werden bzw. durch diese hindurch diffundieren. Die Abgabe der Alkali-Ionen bricht auch bei höheren Temperaturen, z.B. > 600 °C, nicht ab. In einem Hochtemperaturprozess können Verbundhalbleiterschichten ideal aufwachsen, d.h. es kann ein homogenes Kristallwachstum über die Fläche und damit verbunden eine höhere Ausbeute realisiert werden, sowie die Gewährleistung eines genügend großen Alkali-Ionen-Reservoirs während des Abscheidungsprozesses.

Besonders geeignet sind die erfindungsgemäß zu verwendenden Gläser für Technologien auf Basis von Cd-Te sowie Technologien, die auf Kupfer-Indium-Gallium-Sulfid-Selenid, sog. CIS oder CIGS, basieren.

Die erfindungsgemäß verwendeten Gläser sind insbesondere als Substratglas/Superstratglas oder auch als Deckglas im Bereich der Photovoltaik geeignet, insbesondere für die Dünnschicht-Photovoltaik. Superstrate sind Substratgläser, wobei das Substratglas quasi auch als Deckglas fungiert, da bei Dünnschicht-Photovoltaik das beschichtete Glas "umgedreht" wird und die Schicht auf der Unterseite liegt und das Licht durch das Substratglas auf die Photovoltaik-Schicht trifft.

Die erfindungsgemäß verwendeten Gläser stellen insbesondere im Bereich der Photovoltaik eine Alternative zu Kalknatrongläsern dar und können diese in vorteilhafter Weise ersetzen, da bei der Abscheidung von Halbleiterschichten höhere Verfahrenstemperaturen eingesetzt werden können als bei herkömmlichen Kalknatrongläsern, ohne dass sich das Substrat in unvorteilhafter Weise verformt. Verbogenes Substratglas ist problematisch beispielsweise an Prozesskammer-Schleusen und kann zu einem deutlichen Ausbeuteverlust führen. Zusätzlich ist es für den Laminationsprozess von enormem Vorteil, wenn die Solarzellen nicht verbogen sind, auch hier kann nicht ganz planes Substratglas zu einem Ausbeuteverlust führen.

Bei Verwendung eines Substratglases mit einem höheren Tg als Standard-Kalknatronglas werden höhere Prozesstemperaturen während der Halbleiterabscheidung möglich. Höhere Abscheidetemperaturen während der Chalkopyritbildung führen jedoch bekanntermaßen zu einer deutlichen Herabsetzung von Kristallfehlphasen bis unterhalb der Nachweisgrenze. Andererseits sind keine besonders hohen Temperaturen für den Schmelz- und Heissformgebungsprozess des Glases erforderlich, was eine kostengünstige Produktion ermöglicht.

Erstaunlicherweise ermöglichen höhere Prozesstemperaturen auch eine schnellere Prozessierung. Insbesondere Prozesse an der Kristallbildungsfront laufen schneller ab, beispielsweise wird der Einbau der Elemente auf die entsprechenden Kristallplätze beschleunigt. Im Falle der sequentiellen Prozessierung ist ein wesentlicher Mechanismus die Diffusion der einzelnen Atome zur Oberfläche, an welcher die Reaktionen mit den Chalkogen-Atomen stattfinden. Eine höhere Temperatur bedingt eine höhere Diffusionsgeschwindigkeit der Elemente an die Reaktionsfläche, und damit einen schnelleren Transport der für die Kristallbildung benötigten Elemente an die Kristall isationsfront.

Eine gewünscht höhere Temperatur beim Beschichtungsverfahren führt daher zu hohen Abscheidungsraten und zu einer sehr guten kristallinen Qualität der erzeugten Schichten. Ferner tritt beim Abkühlen nach dem Aufbringen der Halbleiterschichten kein Abplatzen der Schichten auf, da das Substratglas vorzugsweise eine geeignete thermische Wärmeausdehnung an den darauf aufgebrachten Halbleiter (z.B. etwa 8,5 x $10^{-6}$/K für CIGS) aufweist.

Insbesondere geeignet sind die erfindungsgemäßen Gläser daher auch für Cd-Te- oder für CIS- bzw. CIGS-Photovoltaik-Anwendungen, insbesondere als Substratglas und/oder Superstratglas und/oder Deckglas. Insbesondere finden die Gläser der Erfindung daher als Dünnschichtsolarzellen-Substrate oder -Superstrate oder -Deckgläser Verwendung. Die Dünnschicht-Photovoltaik wird erfindungsgemäß bevorzugt, da hier wesentlich weniger photoaktives Material für eine effiziente Umwandlung von Sonnenlicht in Elektrizität benötigt wird, als bei herkömmlichen kristallinen, siliciumbasierten Solarzellen. Der geringe Halbleitermaterialverbrauch und die hohe Automatisierung der Fertigung führen zu deutlichen Kostensenkungen bei dieser Technologie.

Bevorzugt wird das erfindungsgemäß eingesetzte Glas daher als Substrat für eine Dünnschichtsolarzelle verwendet. Grundsätzlich unterliegt eine Dünnschichtsolarzelle keinerlei Beschränkung im Hinblick auf deren Form oder auf die Form des Substratglases. Bevorzugt ist die Dünnschichtsolarzelle planar, gewölbt, sphärisch oder zylindrisch ausgebildet, so dass auch das Substrat bevorzugt planar, gewölbt, sphärisch oder zylindrisch ausgebildet ist. Vorzugsweise ist die Dünnschichtsolarzelle eine im wesentlichen planare (flache) Dünnschichtsolarzelle oder eine im wesentlichen rohrförmige Dünnschichtsolarzelle, wobei vorzugsweise flache Substratgläser oder rohrförmige Substratgläser Verwendung finden. Im Falle einer rohrförmigen Dünnschichtsolarzelle beträgt der Außendurchmesser eines rohrförmigen Substratglases der Solarzelle vorzugsweise 5 bis 100 mm und die Wanddicke des rohrförmigen Substratglases vorzugsweise 0,5 bis 10 mm.

Eine Dünnschichtsolarzelle, die ein erfindungsgemäßes Glas verwendet wird vorteilhafterweise nach dem Verfahren, wie beschrieben in der DE 10 2009 020 954 hergestellt, deren Offenbarung hier durch Bezugnahme in die vorliegende Offenbarung vollumfänglich einbezogen ist. Eine derartige Dünnschichtsolarzelle, umfassend das erfindungsgemäß zu verwendende Glassubstrat, weist dann einen um über 2 % absolut höheren Wirkungsgrad im Vergleich zum Stand der Technik auf.

Mit der Lehre der vorliegenden Erfindung können somit kostengünstige, hocheffiziente monolithisch integrierte Photovoltaik-Module auf der Basis von Verbundhalbleitern, wie CdTe oder CIGS, bereitgestellt werden. Die reduzierten Kosten resultieren vor allem durch höhere Wirkungsgrade, schnellere Prozesszeiten und damit höheren Durchsatz, sowie höhere Ausbeuten.

Die Erfindung stellt demnach ein Substratglas zur Verfügung, dem neben seiner Trägerfunktion eine aktive Rolle im Halbleiterherstellungsprozess zukommt, das sich insbesondere durch eine bevorzugt optimale CTE-Anpassung bei hohen Temperaturen an die photoaktive Verbundhalbleiterdünnschicht auszeichnet, sowie durch eine hohe thermische und chemische Stabilität.

Ein bereitgestelltes Dünnschichtsolarmodul kann daher sowohl flach, sphärisch, zylinderförmig sein oder andere geometrische Formen ausweisen. In besonderen Ausführungsformen kann das Glas auch gefärbt sein.

Erfindungsgemäß besonders bevorzugte Gläser sind silikathaltige Gläser, wie Alumosilkatgläser, Borsilikatgläser, Boroaluminosilikatgläser oder Kalknatrongläser mit einem Wassergehalt von < 10 mMol/Liter. Erfindungsgemäß verwendete Gläser, umfassen einen $SiO_2$-Gehalt im Bereich von 40 bis 69 Gew.-%, besonders bevorzugt 40 bis < 61%, noch bevorzugter 45 bis < 61 Gew.-%, ganz besonders bevorzugt 49 bis < 61 Gew.-%, insbesondere 49 bis 60 Gew.-%. Ein derartiger $SiO_2$-Gehalt hat für die Verwendung im Bereich der Photovoltaik den Vorteil, dass weniger Wasser in die CIS- oder CIGS-Schicht eindiffundieren kann. Ferner weisen derartige Gläser eine besonders bevorzugte Alkalidiffusion, insbesondere Natriumdiffusion auf.

In den erfindungsgemäß verwendeten Gläsern sollen keine Verbindungen ausgewählt aus $MnO_2$, $CrO_3$, NiO und/oder Kombinationen hiervon vorhanden sein. In den erfindungsgemäß verwendeten Gläsern sollen auch keine Verbindungen, ausgewählt aus zwei- oder drei-wertigen Oxiden und Fluoriden von Samarium, Europium, Thulium, Terbium, Yttrium, und Ytterbium und/oder Kombinationen hiervon vorliegen.

Erfindungsgemäß verwendete Gläser sind Alumosilikatgläser, umfassend oder bestehend aus der folgenden Glaszusammensetzung (in Gew.-% auf Oxidbasis):

| | |
|---|---|
| $SiO_2$ | 49 - 69 Gew.-%, bevorzugt 49 - < 61 Gew.-% |
| $B_2O_3$ | 0 - 2 Gew.-%, |
| bevorzugt $B_2O_3$ | 0 Gew.-%, |
| $Al_2O_3$ | >4,7 - 19 Gew.-%, |
| bevorzugt $Al_2O_3$ | > 5 - 17 Gew.-%, |
| $Li_2O$ | 0 - 4 Gew.-%, |
| bevorzugt $Li_2O$ | 0 - <0,3 Gew.-%, |
| $Na_2O$ | >10 - 18 Gew.-%, |
| bevorzugt | >15 - 18 Gew.-%, |
| $K_2O$ | >0 - 8 Gew.-%, |
| bevorzugt $K_2O$ | >0 - <5 Gew.-%, |
| insbesondere $K_2O$ | >0 - <4 Gew.-%, wobei die |
| Summe $Li_2O$+ $Na_2O$+ $K_2O$ | >10 - 19 Gew.-% beträgt, und |
| MgO | 0 - 6 Gew.-% |
| CaO | 0 - <5 Gew.-% |
| SrO | 0 - 7 Gew.-%, |
| bevorzugt SrO | 0 - <0,5 Gew.-%, |
| BaO | 0 - 10 Gew.-%, |
| bevorzugt BaO | 1 - 9 Gew.-%, |
| besonders bevorzugt BaO | 2 - 4 Gew.-%, wobei die |
| Summe MgO+CaO+SrO+BaO | 7 - 15 Gew.-% beträgt, und |
| F | 0 - 3 Gew.-% |
| $TiO_2$ | 0 - 6 Gew.-%, |
| bevorzugt $TiO_2$ | >0,1 - 5 Gew.-%, |
| $Fe_2O_3$ | 0 - 0,5 Gew.-% |
| $ZrO_2$ | >0 - 6 Gew.-%, |
| bevorzugt $ZrO_2$ | 1 - 6 Gew.-%, |
| besonders bevorzugt $ZrO_2$ | 1,5 - 5 Gew.-%, wobei |
| die Summe $BaO+ZrO_2$ | 2 - 15 Gew.-% beträgt, |
| bevorzugt | 3 - 15 Gew.-% beträgt, |
| ZnO | 0 - 3 Gew.-%, |
| bevorzugt ZnO | 0 - 2 Gew.-%, |
| besonders bevorzugt | 0,3 - 1,8 Gew.-% |
| $CeO_2$ | 0 - 3 Gew.-% |
| $WO_3$ | 0 - 3 Gew.-% |
| $Bi_2O_3$ | 0 - 3 Gew.-% |
| $MoO_3$ | 0 - 3 Gew.-%, |

wobei der Wassergehalt < 10 mMol/Liter, bevorzugt > 5 mMol/Liter beträgt.

Dem obigen Glas/der Glasschmelze können übliche Läutermittel, wie z.B. Sulfate, Chloride, $Sb_2O_3$, $As_2O_3$, $SnO_2$, zugesetzt werden.

Erfindungsgemäß kommen somit die obigen Alumosilikatgläser zum Einsatz. Diese umfassen als Hauptkomponente $SiO_2$ und $Al_2O_3$ sowie Alkali- und Erdalkalioxide und gegebenenfalls weitere Komponenten.

Das erfindungsgemäß verwendete Grundglas enthält mindestens 49 Gew.-%, vorzugsweise mindestens 50 Gew.-%, insbesondere bevorzugt mindestens 52 Gew.-% an $SiO_2$. Die Höchstmenge an $SiO_2$ beträgt 69 Gew.-%. Ein bevorzugter Bereich des $SiO_2$-Gehalts liegt bei 49 bis < 61 Gew.-%, insbesondere im Bereich von 49 bis 60 Gew.-%.

Die Mindestmenge an $Al_2O_3$ beträgt > 4,7 Gew.-%, besonders bevorzugt > 5 Gew.-%, ganz besonders bevorzugt > 8 Gew.-%. Besonders bevorzugt liegt der $Al_2O_3$-Gehalt ≤ 19 Gew.-%, bevorzugt ≤ 17% und in einer besonders bevorzugten Ausführungsform ≤ 11 Gew.-%, um eine gute Schmelzbarkeit zu ermöglichen. Ganz besonders bevorzugt sind Bereiche von > 5 bis 17 Gew.-%, insbesondere Bereiche von 8 bis 12 Gew.-%. Der Gehalt kann abhängig vom Einsatzzweck variiert werden. Eine Überschreitung des $Al_2O_3$-Gehalts von 19 Gew.-% hat den Nachteil hoher Materialkosten und verschlechterter Einschmelzbarkeit. Eine Unterschreitung eines $Al_2O_3$-Gehalts von 4,7 Gew.-% hat den Nachteil, dass die chemische Beständigkeit des Glases verschlechtert wird und die Neigung zur Kristallisation zunimmt.

Von den Alkalioxiden Lithium, Natrium und Kalium ist insbesondere Natrium von wesentlicher Bedeutung, wie bereits erläutert. $Na_2O$ ist erfindungsgemäß in einer Menge von >10 bis 18 Gew.-%, insbesondere in einer Menge von >11 bis 18 Gew.-%, noch bevorzugter in einer Menge von >12 bis 18 Gew.-%, ganz besonders bevorzugt in einer Menge von >15 bis 18 Gew.-% enthalten. Der Gehalt an $K_2O$ beträgt >0 bis 8 Gew.-%, bevorzugt >0 bis < 5 Gew.-%, bevorzugter >0 bis < 4 Gew.-%. Der $Li_2O$-Gehalt beträgt erfindungsgemäß 0 bis 4 Gew.-%, bevorzugter, 0 bis 1,5 Gew.-%, insbesondere bevorzugt 0 bis < 0,3 Gew.-%. Die Zugabe von $Li_2O$ kann zur Einstellung der thermischen Wärmeausdehnung (CTE) und zur Absenkung der Verarbeitungstemperatur dienen. Insbesondere bevorzugt liegt der $Li_2O$ -Gehalt jedoch bei < 0,3 Gew.-% oder das Glas ist völlig frei von $Li_2O$. Es gibt bisher keine Hinweise, dass $Li_2O$ ähnlich wie $Na_2O$ wirken würde, da dessen Diffusion vermutlich zu hoch ist. Außerdem ist $Li_2O$ als Rohstoff teuer, so dass es vorteilhaft ist, kleinere Mengen einzusetzen.

Eine Überschreitung des jeweils angegebenen Alkalioxid-Gehalts hat den Nachteil, dass sich die Korrossion eines vorhandenen Glaskontaktmaterials verschlechtert. Eine Unterschreitung des jeweiligen Alkalioxid-Gehalts hat den Nachteil, dass die Einschmelzbarkeit verschlechtert wird.

Die Summe $Li_2O + Na_2O + K_2O$ liegt im Bereich >10 bis 19 Gew.-%, bevorzugter im Bereich >12 bis 19 Gew.-%.

Als Erdalkalioxide finden insbesondere Calcium, Magnesium, Barium und in untergeordnetem Maße auch Strontium Verwendung.

CaO wird im Bereich von 0 bis < 5 Gew.-%, bevorzugt 0,3 bis < 4,3 Gew.-%, bevorzugter 0,5 bis < 3 Gew.-%, insbesondere bevorzugt 0,5 bis < 1,5 Gew.-% eingesetzt. MgO wird im Bereich von 0 bis 6 Gew.-%, bevorzugt 0 bis 5 Gew.-%, bevorzugter 0,1 bis 4 Gew.-%, insbesondere bevorzugt 0,5 bis 3,5 Gew.-% eingesetzt. MgO kann zur Verbesserung der Kristallisationsstabilität und Erhöhung der Transformationstemperatur Tg eingesetzt werden. MgO kann in der erfindungsgemäßen Glaszusammensetzung aber auch gänzlich weggelassen werden (MgO = 0 Gew.-%).

BaO wird im Bereich von 0 bis 10 Gew.-%, bevorzugt 1 bis 9 Gew.-%, bevorzugter 2 bis 8 Gew.-%, insbesondere bevorzugt 2 bis 4 Gew.-% eingesetzt. Der Zusatz von BaO kann zur Erhöhung der Transformationstemperatur Tg der Glaszusammensetzung herangezogen werden. BaO kann in der erfindungsgemäß verwendeten Glaszusammensetzung jedoch auch völlig fehlen (BaO = 0 Gew.-%). Die Vorteile eines geringen oder keines BaO-Gehalts sind im Wesentlichen die geringere Dichte und damit Gewichtsreduktion des Glases sowie die Kostenersparnis der teueren Komponente an sich. Die geringe Dichte ist besonders beim Transport des Glases zum Weiterverarbeiter von Vorteil, insbesondere wenn die aus dem Glas hergestellten Produkte in portable Geräte eingebaut werden. Die Gewichtsreduzierung des Glases beträgt bevorzugt >2% (bei einem Gehalt von BaO im Bereich von 3 bis <4 Gew.-%) besonders bevorzugt >5% (bei einem Gehalt von BaO im Bereich von 2 bis 3 Gew.-%) und ganz besonders bevorzugt >8% (bei einem Gehalt von BaO im Bereich von 0 bis 1 Gew.-%). Ein weiterer Vorteil eines BaO-armen bzw. freien Glases ist ebenfalls, dass Barium-Ionen, die beispielsweise in Form von löslichen BariumVerbindungen, als toxisch eingestuft werden, reduziert oder gänzlich weggelassen werden können. Durch Verringern oder völligen Verzicht auf die Gegenwart der Komponente BaO resultiert weiterhin ein deutlicher Kostenvorteil, da BaO relativ teuer ist, was sich bei der großtechnische Herstellung von Glas summiert, und damit zu erheblichen Vorteilen führt.

SrO liegt im erfindungsgemäßen Glas im Bereich von 0 bis 7 Gew.-%, bevorzugt 0 bis <2,5 Gew.-%, insbesondere im Bereich von 0 bis < 0,5 Gew.-% vor. SrO dient im Allgemeinen zu Erhöhung der Transformationstemperatur Tg des Glases. Ganz besonders bevorzugt ist SrO in der erfindungsgemäßen Glaszusammensetzung jedoch nicht enthalten (SrO = 0 Gew.-%). Besondere nachteilige Effekte, wie im Stand der Technik behauptet, konnten hierdurch nicht festgestellt werden.

Die Summe aus MgO+CaO+SrO+BaO liegt erfindungsgemäß im Bereich von 7 bis 15 Gew.-%, bevorzugt im Bereich von 8 bis 14 Gew.-%, bevorzugter im Bereich von 8,5 bis 14 Gew.-%.

$B_2O_3$ ist erfindungsgemäß in einer Menge von 0 bis 2 Gew.-%, bevorzugter 0 bis 1 Gew.-%, ganz besonders bevorzugt 0 - 0,5 Gew.-%, vorhanden. Gemäß einer besonders bevorzugten Ausführungsform ist das Glas frei von $B_2O_3$. Dies ist bevorzugt, da $B_2O_3$ einerseits toxikologisch bedenklich ist (teratogen bzw. fruchtschädigend) und andererseits eine teurere Komponente ist, die den Gemengepreis signifikant erhöht. Höhere Anteile von $B_2O_3$ haben zudem den Nachteil, dass sie sich während der Glasschmelze verflüchtigen, sich im Abgasbereich störend niederschlagen und die Glaszusammensetzung an sich verändern. Weiterhin ist der Zusatz von $B_2O_3$ für die erfindungsgemäßen Anwendungen nachteilig. So hat sich gezeigt, dass sich ein $B_2O_3$-Gehalt über 1 Gew.-% in einem Substratglas nachteilig auf den Wirkungsgrad einer Solarzelle auswirken kann, da Boratome aus dem Substratglas durch Verflüchtigung oder Diffusion in die Halbleiterschichten gelangen, wo diese wahrscheinlich Defekte bewirken, die elektrisch aktiv sind und durch erhöhte Rekombination die Leistung der Zelle herabsetzen können.

Weiterhin ist $ZrO_2$ in einer Menge von > 0 bis 6 Gew.-%, bevorzugt 1 bis 6 Gew.-%, insbesondere 1,5 bis 5 Gew.-% enthalten.

Die Summe BaO + $ZrO_2$ liegt erfindungsgemäß im Bereich von 2 bis 15 Gew.-%, bevorzugt im Bereich von 3 bis 15 Gew.-%.

Darüber hinaus können auch andere Komponenten, wie beispielsweise $WO_3$, $MoO_3$, $Bi_2O_3$, $CeO_2$, $TiO_2$, $Fe_2O_3$, ZnO, F und/oder $CS_2O$ oder auch weitere Komponenten, unabhängig voneinander vorhanden sein.

$WO_3$, $MoO_3$, $Bi_2O_3$ liegen in den erfindungsgemäß verwendeten Alumosilikatgläsern unabhängig voneinander jeweils in einer Menge von 0 bis 3 Gew.-% vor. Diese Komponenten dienen vorzugsweise zur Einstellung der UV-Kante des Glases und können auch als Redox-Puffer zur Läuterung Verwendung finden.

$TiO_2$ und auch $CeO_2$ können üblicherweise zur UV-Blockung des Glases zugegeben werden. Je nach Anwendungsgebiet kann das erfindungsgemäße Glas z.B. in Form eines Deckglases/Hüllrohrs vorliegen und eine Dotierung mit beispielsweise $TiO_2$ und/oder $CeO_2$ aufweisen, um schädliche UV-Strahlung von unterhalb des Glases liegenden Bauteilen fernzuhalten. Der $TiO_2$-Gehalt liegt erfindungsgemäß im Bereich von 0 bis 6 Gew.-%, bevorzugt im Bereich von > 0,1 bis 5 Gew.-%, bevorzugter im Bereich von > 0,1 bis 4 Gew.-%. Jedoch ist ein Gehalt von 0,1 bis 2 Gew.-% besonders bevorzugt, da dann auf toxische Läutermittel, wie $As_2O_3$ und $Sb_2O_3$ gänzlich verzichtet werden kann. $CeO_2$ liegt erfindungsgemäß in einem Bereich von 0 bis 3 Gew.-%.

$Fe_2O_3$ findet in einer Menge von 0 bis 0,5 Gew.-% Verwendung und dient üblicherweise zur Einstellung der UV-Blockung, kann aber auch als Redox-Puffer für die Läuterung eingesetzt werden.

Weiterhin kann dem erfindungsgemäß verwendeten Glas zur Verbesserung der Schmelzbarkeit Fluor in Form von Fluoridsalzen, wie z.B. NaF, zugesetzt werden. Die Menge, die in der Glaszusammensetzung eingesetzt wird, beträgt von 0 bis 3 Gew.-%.

Es können übliche Läutermittel zum Einsatz kommen, sofern diese die chemischen und physikalischen Eigenschaften der erfindungsgemäß verwendeten Glaszusammensetzung nicht nachteilig beeinflussen. Beispielsweise ist eine Läuterung mit Sulfaten, Chloriden, $Sb_2O_3$, $As_2O_3$ und/oder $SnO_2$ möglich. Die Läutermittel sind bevorzugt jeweils für sich im Glas in einer Menge von > 0 - 1 Gew.-% enthalten, wobei der Mindestgehalt vorzugsweise 0,1, insbesondere 0,2 Gew.-% beträgt.

Nachfolgend wird die vorliegende Erfindung anhand von Beispielen erläutert, welche die erfindungsgemäße Lehre veranschaulichen, diese aber nicht beschränken sollen.

Vergleichsbeispiele

Es wurden Glaszusammensetzungen ausgewählt und hieraus Gläser hergestellt. Die Gläser wurden in 4-Liter Platintiegeln aus herkömmlichen Rohstoffen erschmolzen. Um einen Restwassergehalt im Glas zu gewährleisten, wurde der Al-Rohstoff $Al(OH)_3$ eingesetzt und zudem kam ein Sauerstoffbrenner im Ofenraum des gasbeheizten Schmelzofens (Oxyfueltechnik) zur Erzielung der hohen Schmelztemperaturen bei oxidierender Schmelzführung zum Einsatz. Die Rohstoffe wurden über einen Zeitraum von 8h bei Schmelztemperaturen von 1580°C eingelegt und anschließend 14h lang auf dieser Temperatur gehalten. Unter Rühren wurde dann die Glasschmelze innerhalb von 8h auf 1400°C abgekühlt und anschließend in eine auf 500°C vorgeheizte Graphitform gegossen. Diese Gussform wurde unmittelbar nach dem Guss in einen auf 650°C vorgeheizten Kühlofen verbracht, der mit 5°C/h auf Raumtemperatur abkühlte. Aus diesem Block wurden danach die für die Messungen notwendigen Glasproben entnommen. In den nachfolgenden Tabellen 1 und 2 sind die Zusammensetzungen und Eigenschaften der verwendeten Gläser zusammengefasst.

**Tabelle 1**

| [in Gew.-%] | V1a | V1b | V2a | V2b | V3a | V3b |
|---|---|---|---|---|---|---|
| $SiO_2$ | 62,90 | 62,90 | 60,60 | 60,60 | 59,45 | 59,45 |
| $B_2O_3$ | | | | | 0,5 | 0,5 |
| $Al_2O_3$ | 17,00 | 17,00 | 17,00 | 17,00 | 11,0 | 11,0 |

(fortgesetzt)

| [in Gew.-%] | V1a | V1b | V2a | V2b | V3a | V3b |
|---|---|---|---|---|---|---|
| Na$_2$O | 12,00 | 12,00 | 12,00 | 12,00 | 12,00 | 12,00 |
| K$_2$O | 4,00 | 4,00 | 4,00 | 4,00 | 6,00 | 6,00 |
| MgO | 3,70 | 3,70 | 4,00 | 4,00 | 3,50 | 3,50 |
| CaO | 0,30 | 0,30 | | | 1,00 | 1,00 |
| BaO | | | | | 4,00 | 4,00 |
| SrO | | | | | | |
| ZrO$_2$ | | | 1,50 | 1,50 | 2,50 | 2,50 |
| TiO$_2$ | | | | | | |
| CeO$_2$ | | | 0,10 | 0,10 | | |
| SO$_3$ | | | | | | |
| SnO$_2$ | | | 0,50 | 0,50 | | |
| F | | | 0,30 | 0,30 | | |
| Sb$_2$O$_3$ | | | | | 0,05 | 0,05 |
| As$_2$O$_3$ | 0,10 | 0,10 | | | | |
| Wassergehalt mMol/Liter | 23 | 30 | 20 | 45 | 20 | 50 |
| Summe | 100,00 | 100,00 | 100,00 | 100,00 | 100,00 | 100,00 |

**Tabelle 2**

| [in Gew.-%] | V4a | V4b | V5a | V5b | V6a | V6b |
|---|---|---|---|---|---|---|
| SiO$_2$ | 52,8 | 52,8 | 53,6 | 53,6 | 61,5 | 61,5 |
| B$_2$O$_3$ | -- | -- | -- | -- | -- | -- |
| Al$_2$O$_3$ | 13,7 | 13,7 | 14,5 | 14,5 | 16,8 | 16,8 |
| Na$_2$O | 11,3 | 11,3 | 11,5 | 11,5 | 12,2 | 12,2 |
| K$_2$O | 3,2 | 3,2 | 3,3 | 3,3 | 4,1 | 4,1 |
| MgO | 3,0 | 3,0 | 2,7 | 2,7 | 3,9 | 3,9 |
| CaO | 4,2 | 4,2 | 3,8 | 3,8 | -- | -- |
| SrO | -- | -- | -- | -- | -- | -- |
| BaO | 7,5 | 7,5 | 5,3 | 5,3 | -- | -- |
| ZrO$_2$ | 3,7 | 3,7 | 3,5 | 3,5 | 1,5 | 1,5 |
| Cl | 0,5 | 0,5 | 0,5 | 0,5 | -- | -- |
| SO$_3$ | 0,1 | 0,1 | 0,1 | 0,1 | -- | -- |
| ZnO | -- | -- | 1,2 | 1,2 | -- | -- |
| F | -- | -- | -- | -- | -- | -- |
| As$_2$O$_3$ | -- | -- | -- | -- | -- | -- |
| Wassergehalt mMol/Liter | 18 | 35 | 20 | 40 | 19 | 30 |
| Summe | 100,00 | 100,00 | 100,00 | 100,00 | 100,00 | 100,00 |

Die Beispiele V1a, V2a, V3a, V4a, V5a und V6a sind Glaszusammensetzungen, die einen Wassergehalt unter 25 mMol/Liter enthalten, die Beispiele V1b, V2b, V3b,V4b, V5b und V6b sind Glaszusammensetzungen, deren Wassergehalt höher liegt. Der höhere Wassergehalt ist nachteilig, da größere Mengen des Halbleitergiftes Wasser in die photoaktiven Schichten diffundieren können und zu einer Verringerung des Wirkungsgrades führen.

Mit der vorliegenden Erfindung werden somit in der Photovoltaik zu verwendende Glaszusammensetzungen beschrieben, die eine Alternative zu Kalknatrongläsern darstellen, und aufgrund eines Wassergehalts von < 10 mMol/Liter besonders vorteilhafte Eigenschaften aufweisen. Der in den Gläsern vorhandene Wassergehalt von < 10 mMol/Liter bewirkt, dass diese Gläser in einem Hochtemperaturprozess eingesetzt werden könne, ohne Halbleitergifte, wie Eisen, Arsen und Bor, freizusetzen. Die Beweglichkeit von Alkali-Ionen ist in diesen Gläsern mit geringem Wassergehalt in hohem Maße gegeben, so dass die lonenbeweglichkeit der Natrium-Ionen und deren leichtere Austauschbarkeit durch den geringen Restwassergehalt in der Glasstruktur positiv beeinflusst wird. Die Alkali-Ionen können räumlich homogen über die gesamte Substratfläche an die darüber liegenden Schichten abgegeben werden bzw. durch diese hindurch diffundieren.

Ein Wassergehalt von 25 mMol/Liter oder mehr kann insbesondere für Photovoltaik-Anwendungen im CIGS-Bereich (Kupfer-Indium-Gallium-Schwefel oder Selen) nachteilig sein, da die Leistungsfähigkeit einer Photovoltaik-Solarzelle abnehmen kann. Der erfindungsgemäß bevorzugte Wassergehalt im Bereich zwischen 1 und 10 mMol/Liter wirkt sich in keiner Weise nachteilig auf die Glaseigenschaften der Gläser aus, wohingegen ein Wassergehalten über 25 mMol/Liter durchaus zu unvorteilhaften Änderungen der Glaseigenschaften führen kann.

Besonders bevorzugt sind Gläser mit einer ähnlichen thermischen Dehnung von 8 bis 10 x $10^{-6}$/K, aber einer höheren thermischen Belastbarkeit (Tg) bei gleichzeitig ähnlichen bzw. nur geringfügig erhöhten Verarbeitungstemperaturen (VA) im Vergleich zu Kalknatrongläsern. Die erfindungsgemäß zu verwendenden Gläser sind insbesondere für Cd-Te- oder für CIS- bzw. CIGS-Photovoltaik-Anwendungen geeignet, da die Prozessierbarkeit/Abscheidung gegenüber den traditionell verwendeten Kalknatrongläsern aufgrund höherer Temperaturstabilität bei höheren Temperaturen erfolgen kann, was große Vorteile mit sich bringt.

**Patentansprüche**

1. Verwendung eines Glases für Photovoltaik-Anwendungen, wobei das Glas einen Wassergehalt von < 10 mMol/Liter aufweist und die folgende Glaszusammensetzung (in Gew.-% auf Oxidbasis) aufweist oder hieraus besteht:

| | |
|---|---|
| $SiO_2$ | 49 - 69 Gew.-% |
| $B_2O_3$ | 0 - 2 Gew.-%, |
| bevorzugt $B_2O_3$ | 0 Gew.-%, |
| $Al_2O_3$ | >4,7 - 19 Gew.-%, |
| bevorzugt $Al_2O_3$ | > 5 - 17 Gew.-%, |
| $Li_2O$ | 0 - 4 Gew.-%, |
| bevorzugt $Li_2O$ | 0 - <0,3 Gew.-%, |
| $Na_2O$ | >10 - 18 Gew.-%, |
| bevorzugt | >15 - 18 Gew.-%, |
| $K_2O$ | >0 - 8 Gew.-%, |
| bevorzugt $K_2O$ | >0 - <5 Gew.-%, |
| insbesondere $K_2O$ | >0 - <4 Gew.-%, wobei die |
| Summe $Li_2O+ Na_2O+ K_2O$ | >10 - 19 Gew.-% beträgt, und |
| MgO | 0 - 6 Gew.-% |
| CaO | 0 - <5 Gew.-% |
| SrO | 0 - 7 Gew.-%, |
| bevorzugt SrO | 0 - <0,5 Gew.-%, |
| BaO | 0 - 10 Gew.-%, |
| bevorzugt BaO | 1 - 9 Gew.-%, |
| besonders bevorzugt BaO | 2 - 4 Gew.-%, wobei die |
| Summe MgO+CaO+SrO+BaO | 7 - 15 Gew.-% beträgt, und |
| F | 0 - 3 Gew.-% |
| $TiO_2$ | 0 - 6 Gew.-%, |
| bevorzugt $TiO_2$ | >0,1 - 5 Gew.-%, |
| $Fe_2O_3$ | 0 - 0,5 Gew.-% |

(fortgesetzt)

| | |
|---|---|
| $ZrO_2$ | >0 - 6 Gew.-%, |
| bevorzugt $ZrO_2$ | 1 - 6 Gew.-%, |
| besonders bevorzugt $ZrO_2$ | 1,5 - 5 Gew.-%, wobei |
| die Summe $BaO+ZrO_2$ | 2 - 15 Gew.-% beträgt, |
| bevorzugt | 3 - 15 Gew.-% beträgt, |
| ZnO | 0 - 3 Gew.-%, |
| bevorzugt ZnO | 0 - 2 Gew.-%, |
| besonders bevorzugt | 0,3 - 1,8 Gew.-% |
| $CeO_2$ | 0 - 3 Gew.-% |
| $WO_3$ | 0 - 3 Gew.-% |
| $Bi_2O_3$ | 0 - 3 Gew.-% |
| $MoO_3$ | 0 - 3 Gew.-%, |

wobei das Glas übliche Läutermittel, wie z.B. Sulfate, Chloride, $Sb_2O_3$, $As_2O_3$, $SnO_2$ aufweist.

2. Verwendung nach Anspruch 1 **dadurch gekennzeichnet, dass** die Photovoltaik-Anwendungen ausgewählt sind aus Cd-Te-, CIS- oder CIGS-Photovoltaik-Anwendungen.

3. Verwendung nach mindestens einem der vorangehenden Ansprüche, **dadurch gekennzeichnet, dass** die Photvoltaik-Anwendungen Dünnschicht-Photovoltaik-Anwendungen darstellen.

4. Verwendung nach mindestens einem der vorangehenden Ansprüche, **dadurch gekennzeichnet, dass** das Glas als Substratglas, Superstratglas und/oder Deckglas verwendet wird.

5. Verwendung nach mindestens einem der vorangehenden Ansprüche, **dadurch gekennzeichnet, dass** das Glas als Substrat in einer Dünnschichtsolarzelle verwendet wird.

6. Verwendung nach mindestens einem der vorangehenden Ansprüche, **dadurch gekennzeichnet, dass** das Glas als Substrat in einer planaren, gewölbten, sphärischen oder zylindrischen Form verwendet wird.

7. Verwendung nach mindestens einem der vorangehenden Ansprüche, **dadurch gekennzeichnet, dass** das Glas einen $Na_2O$-Gehalt > 10 Gew.-%, bevorzugt > 12 Gew.-%, besonders bevorzugt > 15 Gew.-% aufweist.

8. Verwendung nach mindestens einem der vorangehenden Ansprüche, **dadurch gekennzeichnet, dass** das Glas eine Transformationstemperatur Tg im Bereich von > 580°C, bevorzugt > 600°C aufweist

9. Verwendung nach mindestens einem der vorangehenden Ansprüche, **dadurch gekennzeichnet, dass** das Glas eine Verarbeitungstemperatur ("VA") im Bereich von < 1270°C, bevorzugt <1200°C und ganz besonders bevorzugt <1150°C aufweist.

10. Verwendung nach mindestens einem der vorangehenden Ansprüche, **dadurch gekennzeichnet, dass** das Glas einen thermischen Wärmeausdehnungskoeffizienten von 7 bis 11 x $10^{-6}$/K, bevorzugter 8 bis 10 x $10^{-6}$/K, ganz besonders bevorzugt 8,5 bis 10 x $10^{-6}$/K im Temperaturbereich von 20 bis 300°C aufweist.

**Claims**

1. Use of a glass for photovoltaic applications, wherein the glass has a water content of < 10 mmol/liter and the following glass composition (in wt.% based on oxide) has or consists of the following:

| | |
|---|---|
| $SiO_2$ | 49-69 wt.% |
| $B_2O_3$ | 0-2 wt.%, |
| preferably $B_2O_3$ | 0 wt.%, |
| $Al_2O_3$ | >4.7-19 wt.%, |

(continued)

| | |
|---|---|
| preferably $Al_2O_3$ | >5-17 wt.%, |
| $Li_2O$ | 0-4 wt.%, |
| preferably $Li_2O$ | 0-<0.3 wt.%, |
| $Na_2O$ | >10-18 wt.%, |
| preferably | >15-18 wt.%, |
| $K_2O$ | >0-8 wt.%, |
| preferably $K_2O$ | >0-<5 wt.%, |
| in particular $K_2O$ | >0-<4 wt.%, wherein the |
| sum $Li_2O + Na_2O + K_2O$ is | >10-19 wt.%, and |
| MgO | 0-6 wt.% |
| CaO | 0-<5 wt.% |
| SrO | 0-7 wt.%, |
| preferably SrO | 0-<0.5 wt.%, |
| BaO | 0-10 wt.%, |
| preferably BaO | 1-9 wt.%, |
| more preferably BaO | 2-4 wt.%, wherein the |
| sum MgO+CaO+SrO+BaO is | 7-15 wt.%, and |
| F | 0-3 wt.% |
| $TiO_2$ | 0-6 wt.%, |
| preferably $TiO_2$ | >0.1-5 wt.%, |
| $Fe_2O_3$ | >0-0.5 wt.% |
| $ZrO_2$ | >0-6 wt.%, |
| preferably $ZrO_2$ | 1-6 wt.%, |
| more preferably $ZrO_2$ | >1.5-5 wt.%, wherein |
| the sum $BaO+ZrO_2$ is | 2-15 wt.%, |
| preferably | 3-15wt.%, |
| ZnO | 0-3 wt.%, |
| preferably ZnO | 0-2 wt.%, |
| more preferably | 0.3-1.8 wt.% |
| $CeO_2$ | 0-3 wt.% |
| $WO_3$ | 0-3 wt.% |
| $Bi_2O_3$ | 0-3 wt.% |
| $MoO_3$ | 0-3 wt.%, |

wherein the glass contains customary refining agents such as, for example, sulfates, chlorides, $Sb_2O_3$, $As_2O_3$, $SnO_2$.

2. Use according to claim 1, **characterized in that** the photovoltaic applications are selected from Cd-Te, CIS or CIGS photovoltaic applications.

3. Use according to at least one of the preceding claims, **characterized in that** the photovoltaic applications are thin film photovoltaic applications.

4. Use according to at least one of the preceding claims, **characterized in that** the glass is used as substrate glass, superstrate glass and/or cover glass.

5. Use according to at least one of the preceding claims, **characterized in that** the glass is used as a substrate in a thin film solar cell.

6. Use according to at least one of the preceding claims, **characterized in that** the glass is used as a substrate in a planar, curved, spherical or cylindrical shape.

7. Use according to at least one of the preceding claims, **characterized in that** the glass has an $Na_2O$ content of >10

wt.%, preferably >12 wt.%, more preferably >15 wt.%.

8. Use according to at least one of the preceding claims, **characterized in that** the glass has a transformation temperature Tg in the range of >580°C, preferably >600°C.

9. Use according to at least one of the preceding claims, **characterized in that** the glass has a processing temperature ("VA") in the range of <1270°C, preferably <1200°C and more preferably <1150°C.

10. Use according to at least one of the preceding claims, **characterized in that** the glass has a coefficient of thermal expansion of 7 to $11 \times 10^{-6}$/K, preferably 8 to $10 \times 10^{-6}$/K, more preferably 8.5 to $10 \times 10^{-6}$/K in the temperature range of 20 to 300°C.

**Revendications**

1. Utilisation d'un verre pour applications photovoltaïques, lequel verre contient une teneur en eau de < 10 mmol/litre et contenant ou se composant de la composition de verre suivante (en % du poids d'oxydes) :

| | |
|---|---|
| $SiO_2$ | 49 à 69 % en poids |
| $B_2O_3$ | 0 à 2 % en poids, |
| de préférence $B_2O_3$ | 0 % en poids, |
| $Al_2O_3$ | > 4,7 à 19 % en poids, |
| de préférence $Al_2O_3$ | > 5 à 17 % en poids, |
| $Li_2O$ | 0 à 4 % en poids, |
| de préférence $Li_2O$ | 0 à < 0,3 % en poids, |
| $Na_2O$ | > 10 à 18 % en poids, |
| de préférence | > 15 à 18 % en poids, |
| $K_2O$ | > 0 à 8 % en poids, |
| de préférence $K_2O$ | > 0 à < 5 % en poids, |
| en particulier $K_2O$ | > 0 à < 4 % en poids, |
| la somme de $Li_2O + Na_2O + K_2O$ étant de | > 10 à 19 % en poids, et |
| MgO | 0 à 6 % en poids |
| CaO | 0 à < 5 % en poids |
| SrO | 0 à 7 % en poids, |
| de préférence SrO | 0 à < 0,5 % en poids, |
| BaO | 0 à 10 % en poids, |
| de préférence BaO | 1 à 9 % en poids, |
| en particulier BaO | 2 à 4 % en poids, |
| la somme de MgO+CaO+SrO+BaO étant | de 7 à 15 % en poids, et |
| F | 0 à 3 % en poids |
| $TiO_2$ | 0 à 6 % en poids, |
| de préférence $TiO_2$ | > 0,1 à 5 % en poids, |
| $Fe_2O_3$ | 0 à 0,5 % en poids, |
| $ZrO_2$ | > 0 à 6 % en poids, |
| de préférence $ZrO_2$ | 1 à 6 % en poids |
| en particulier $ZrO_2$ | 1,5 à 5 % en poids, |
| la somme de $BaO+ZrO_2$ étant de | 2 à 15 % en poids, |
| de préférence | 3 à 15 % en poids, |
| ZnO | 0 à 3 % en poids, |
| de préférence ZnO | 0 à 2 % en poids, |
| en particulier | 0,3 à 1,8 % en poids |
| $CeO_2$ | 0 à 3 % en poids |
| $WO_3$ | 0 à 3 % en poids |
| $Bi_2O_3$ | 0 à 3 % en poids |

(suite)

| MoO$_3$ | 0 à 3 % en poids, |
|---|---|

le verre contenant des agents d'affinage usuels, par exemple des sulfates, des chlorures, du Sb$_2$O$_3$, de l'As$_2$O$_3$ du Sn$_2$O$_2$, etc.

2. Utilisation selon la revendication 1, **caractérisée en ce que** les applications photovoltaïques sont choisies parmi les applications photovoltaïques Cd-Te, CIS ou CIGS.

3. Utilisation selon l'une au moins des revendications précédentes, **caractérisée en ce que** les applications photovoltaïques représentent des applications photovoltaïques à couches minces.

4. Utilisation selon l'une au moins des revendications précédentes, **caractérisée en ce que** le verre est utilisé comme verre de substrat, de superstrat et/ou de couverture.

5. Utilisation selon l'une au moins des revendications précédentes, **caractérisée en ce que** le verre est utilisé comme substrat d'une cellule photovoltaïque à couches minces.

6. Utilisation selon l'une au moins des revendications précédentes, **caractérisée en ce que** le verre est utilisé comme substrat sous une forme plane, bombée, sphérique ou cylindrique.

7. Utilisation selon l'une au moins des revendications précédentes, **caractérisée en ce que** le verre contient une proportion de Na$_2$O supérieure à 10 % en poids, de préférence supérieure à 12 % en poids, en particulier supérieure à 15 % en poids.

8. Utilisation selon l'une au moins des revendications précédentes, **caractérisée en ce que** la température de transformation Tg du verre se situe dans une plage de > 580 °C, de préférence > 600 °C.

9. Utilisation selon l'une au moins des revendications précédentes, **caractérisée en ce que** la température de mise en oeuvre (« VA ») du verre se situe dans une plage de < 1270 °C, de préférence < 1200 °C et en particulier < 1150 °C.

10. Utilisation selon l'une au moins des revendications précédentes, **caractérisée en ce que** le coefficient de dilatation thermique du verre est de 7 à 11 × 10$^{-6}$/K, de préférence de 8 à 10 × 10$^{-6}$/K, en particulier de 8,5 à 10 × 10$^{-6}$/K dans la plage de températures de 20 à 300 °C.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4333407 C1
- WO 9407269 A1
- DE 10005088 C1
- JP 11135819 A
- DE 102006062448 A1
- DE 102009020954
- DE 102009050987 B3

- WO 2011091961 A1
- EP 2383793 A1
- WO 2011049146 A1
- WO 2010050591 A1
- US 20050003136 A1
- EP 2492246 A1